# EUROPÄISCHE PATENTSCHRIFT

(11) **EP 0 851 721 B1**
(45) Veröffentlichungstag und Bekanntmachung des Hinweises auf die Patenterteilung: **12.02.2003**
(21) Anmeldenummer: 97120177.7
(22) Anmeldetag: 18.11.1997
(51) Int. Cl.: H05K 1/05

(54) **Trennbare Platine für integrierte elektronische Schaltungen, Verfahren zur Herstellung einer Platine sowie Verwendung**
Separable plate for integrated electronic circuits, process for manufacturing a plate, and its use
Platine séparable pour circuits électroniques intégrés, procédé de fabrication d'une platine ainsi que son utilisation

(30) Priorität: 28.11.1996 DE 19649454
(43) Veröffentlichungstag der Anmeldung: 01.07.1998
(73) Patentinhaber: ALCAN DEUTSCHLAND GMBH, D-37075 Göttingen (DE)
(72) Erfinder: Böttger, Dietmar, 58762 Altena (DE)
(74) Vertreter: Füchsle, Klaus, Dipl.-Ing.

(56) Entgegenhaltungen:
- DE-A- 4 412 364
- DE-A- 4 439 239
- US-A- 4 675 784
- US-A- 5 230 788
- US-A- 5 582 884
- PATENT ABSTRACTS OF JAPAN vol. 18, no. 480 (E-1603), 8. September 1994 (1994-09-08) & JP 06 164086 A (HITACHI), 10. Juni 1994 (1994-06-10)

## Beschreibung

Die Erfindung betrifft eine trennbare Platine für integrierte elektronische Schaltungen, ein Verfahren zur Herstellung einer Platine sowie eine Verwendung.

Im allgemeinen bestehen die in der Technik bekannten Platinen für integrierte elektronische Schaltungen aus Isolierstoffplatten, die einseitig oder beidseitig mit einer Kupferschicht versehen werden, in die mittels Druck- und Ätztechniken Leiterbahnen eingearbeitet werden. Die Isolierstoffplatten können beispielsweise aus Schichtpreßstoffen, wie Papier oder Hartfasergewebe, das in Epoxidharz eingebettet ist, Kunstharzen oder Keramikwerkstoffen bestehen. Zur Ausbildung integrierter elektronischer Schaltungen werden elektronische Bauelemente wie z.B. Widerstände, Spulen, Transistoren, Kondensatoren oder integrierte Schaltkreise in Bohrungen eingelötet, die in den auf der Platine ausgebildeten Leiterbahnen vorgesehen sind. Alternativ können die genannten Bauteile als SMD-Bauelemente (surface mounted device) auf die Leiterbahnen aufgelötet werden.

Derartige Platinen werden zumeist in industrieller Serienfertigung mit Handhabungsgeräten automatisch bestückt, was eine ausreichende Stabilität und eine gewisse Dicke der Platinen erfordert. Ferner müssen die Platinen für die im Rahmen der betrieblichen Nutzung auftretenden Belastungen hinreichend stabil sein. Die folglich vergleichsweise dick ausgebildeten Platinen werfen besondere Probleme bei der Verschrottung und Entsorgung dieser Bestandteile elektronischer Geräte am Ende von deren Nutzungsdauer auf. Der größte Volumenanteil einer zu entsorgenden Platine wird nämlich durch die festen und dicken Isolierstoffplatten gebildet, die als Trägerplatte für die Leiterbahnen und die darauf befindlichen Bauteile dienen. Die Werkstoffe der Isolierstoffplatten sind zwar nur selten wiederverwertbar, sie sind jedoch relativ einfach zu entsorgen und stellen meist keinen Problemmüll dar. Wie vorangehend beschrieben, sind mit den Isolierstoffplatten jedoch elektronische Bauelemente fest verbunden, die entweder kritischen Sondermüll bilden, der getrennt aufzubereiten oder zu entsorgen ist, oder aus wertvollen Werkstoffen bestehen, für die eine Wiederverwertbarkeit erwünscht wäre. Aufgrund der gemäß dem Stand der Technik festen Verbindung zwischen den auf der Leiterplatte befindlichen elektronischen Bauteilen und den vergleichsweise dicken Isolierstoffplatten tritt das Problem auf, daß die an sich unproblematischen Isolierstoffplatten zusammen mit den kritischen, darauf befestigten Bauteilen entsorgt werden müssen. Wie erwähnt, ist die Verbindung zwischen den genannten Komponenten nicht ohne weiteres zu lösen, und es kann nicht in Kauf genommen werden, die kritischen elektronischen Bauteile zusammen mit den Isolierstoffplatten zu deponieren. Die Notwendigkeit, ein großes Volumen an Isolierstoffplatten als Sondermüll zu entsorgen, führt zu unerwünscht hohen Kosten. Ferner können die elektronischen Bauteile nicht ohne weiteres einer Wiederverwendung zugeführt werden, solange sie mit der Platine fest verbunden sind.

In der Vergangenheit wurden Versuche dahingehend unternommen, die Leiterplatten als Folie auf eine dicke Trägerplatte mit Hilfe eines leicht ablösbaren Klebers aufzubringen. Diese Kleberschicht löst sich jedoch zumeist in den Durchlauflötöfen, die bei der Bestückung derartiger Leiterplatten verwendet werden, und in denen Temperaturen von ca. 200°C bis 250°C herrschen. Folglich erfüllt eine derartige Platine die bei der Herstellung und Weiterverarbeitung gestellten Anforderungen nicht.

Aus der DE 44 12 364 A1 ist eine Leiterplatte bekannt, bei der ein Foliensystem lösbar auf einen Träger laminiert ist. An einer an der Stirnseite vorgesehenen Trennstelle kann die Abtrennung ausgelöst werden, um nachfolgend die jeweiligen Rohstoffe der Wiederverwertung zuzuführen.

In der DE 44 39 239 A1 ist für einen beidseitig beschichteten Träger mit Durchkontaktierungen eine Möglichkeit beschrieben, wie die auflaminierten Foliensysteme vollständig von dem Träger gelöst werden können. Durch lösbare Verbindungen zwischen den Folien und den Signalübertragungswegen können auch in diesem Fall die Folien mit den daran befindlichen Bauteilen in den Stoffkreislauf zurückgeführt werden.

Aus der US 5,230,788 ist es bekannt, eine Oberfläche einer Metallplatte zweifach zu anodisieren. Hierdurch wird an dem Träger einer Platine eine Oxidschicht ausgebildet, die gute Wärmeleiteigenschaften zur Ableitung der in den Bauteilen entstehenden Wärme auf die Trägerplatte und hervorragende elektrische Isoliereigenschaften aufweist. Das Problem, die unterschiedlichen beteiligten Rohstoffe getrennt wiederverwertbar zu machen, wird hierdurch nicht gelöst.

Eine Leiterplatte mit einer derartigen Oxidschicht ist in der US 4,675,784 offenbart. Auch in diesem Zusammenhang wird die Oxidschicht als Isolierung genutzt, und die beschriebene Leiterplatte ist dahingehend nachteilig, daß eine Auftrennung zur getrennten Verwertung der beteiligten Rohstoffe nicht möglich ist. Die Verwendung einer Oxidschicht auf einer Trägerplatte aus Aluminium als Isolierschicht wird auch durch das "Handbuch der Leiterplattentechnik" von Herbert Bruch et al., Eugen G. Leuze Verlag, Saulgau/Württ., Seite 322 gelehrt.

In Anbetracht der genannten Nachteile der im Stand der Technik bekannten Platinen für integrierte elektronische Schaltungen besteht die Aufgabe der vorliegenden Erfindung darin, eine Platine zu schaffen, die hinsichtlich ihrer mechanischen Festigkeit und Wärmebeständigkeit den Anforderungen, wie sie bei einer industriellen Serienfertigung auftreten, entspricht, und bei der gleichzeitig mit wenig Aufwand und in einfacher Weise eine getrennte Entsorgung der Bestandteile der Platine gewährleistet werden kann. Ferner besteht die Aufgabe der Erfindung darin, ein Herstellungsverfahren für eine Platine zu schaffen, durch das mit geringem Aufwand eine Platine hergestellt werden kann, die den obengenannten Anforderungen entspricht.

Die Lösung dieser Aufgabe erfolgt zum einen durch eine Platine mit den Merkmalen des Anspruchs 1.

Demzufolge besteht die erfindungsgemäße Platine für integrierte elektronische Schaltungen aus einer Trägerplatte aus Metall, die im Bereich zumindest einer ihrer Oberflächen eine gegen mechanische Belastungen vergleichsweise schwache Zwischenschicht aus hitzebeständigem Material aufweist, die als poröse Oxidschicht an der Oberfläche der metallenen Trägerplatte ausgebildet ist. Ferner ist zumindest eine Leiterplatte in Form einer vergleichsweise dünnen Folie oder Karte mittels eines nur schwer wieder lösbaren Haftmittels an der mit der vergleichsweise schwachen Zwischenschicht versehenen Oberfläche der Trägerplatte angebracht. Durch diese Ausbildung der Platine ist die Leiterplatte, insbesondere zur getrennten Entsorgung, entlang der Zwischenschicht von der Trägerplatte abtrennbar. Erfindungsgemäß wird durch die Oxidschicht eine Schicht ausgebildet, die innerhalb des Gesamtverbundes die Ebene mit der geringsten Trennfestigkeit darstellt. Insbesondere liegt die Trennfestigkeit und die folglich zum Abtrennen entlang dieser Ebene erforderliche Kraft unterhalb der Trennfestigkeit bzw. der Trennkraft, welche die Haftmittelschicht aufweist, durch welche die Leiterplatte mit der Trägerplatte verbunden ist. Hierbei kann die Platine entweder einseitig oder beidseitig mit Leiterplatten bestückt sein.

Eine Abtrennung der Leiterplatte entlang der Zwischenschicht kann auch vorgenommen werden, wenn die Leiterplatte für besondere Anwendungen in dünner, biegsamer Form zum Einsatz kommen soll.

Mit Hilfe der genannten Zwischenschicht aus hitzebeständigem Material kann auch bei den Prozeßtemperaturen, wie sie bei der Bearbeitung derartiger Platinen auftreten, die feste Verbindung innerhalb der Trägerplatte und damit zwischen der Trägerplatte und der auf zumindest einer Oberfläche der Trägerplatte angebrachten Zwischenschicht gewährleistet werden. Gleichzeitig wird mit der Zwischenschicht, die erfindungsgemäß gegen mechanische Belastungen vergleichsweise schwach ausgebildet ist, die Möglichkeit geschaffen, im Rahmen der Entsorgung einer derartigen Platine die angebrachten Leiterplatten zusammen mit den kritischen elektronischen Bauteilen von einem wesentlichen Teil der Trägerplatte zu lösen. Folglich sind diese Bestandteile der Platine problemlos getrennt voneinander entsorgbar. Ferner kann durch die nachfolgend beschriebenen bevorzugten Ausführungsformen der Erfindung sowohl für die Zwischenschicht als auch für die Haftmittelschicht eine derartige Festigkeit sichergestellt werden, daß diese den Belastungen, die bei der Bestückung und Handhabung derartiger Platinen auftreten, standhält. Gegebenenfalls kann die abgelöste Leiterplatte zumindest teilweise wiederverwertet werden. Die Trägerplatte kann entweder deponiert oder eingeschmolzen und wiederverwertet werden.

Erfindungsgemäß besteht die Trägerplatte somit aus Metall, und an zumindest einer Oberfläche der metallenen Trägerplatte ist eine Oxidschicht ausgebildet, in der die vergleichsweise schwache Zwischenschicht vorgesehen ist. Die Oxidschicht wird auf der Oberfläche der Trägerplatte durch elektrochemische Oxidation erzeugt. Dabei bilden sich in der Oxidschicht eine Vielzahl tiefer Poren aus. Zur Ausbildung der erfindungsgemäßen, vergleichsweise schwachen Zwischenschicht in der Oxidschicht wird diese bei reduzierter Spannung fortgesetzt anodisiert, wodurch sich in dem Verlauf der Porenöffnungen zusätzlich geschwächte Bereiche ausbilden, die in ihrer Gesamtheit eine deutlich geschwächte Schicht innerhalb der Oxidschicht bilden. Entlang dieser Schicht erfolgt bei der Trennung der erfindungsgemäßen Platine das Lösen der aufgebrachten Leiterplatten von der Trägerplatte. Mit Hilfe der genannten Ausbildung der erfindungsgemäßen Platine konnten bei geringem Aufwand besonders gute Ergebnisse und Bearbeitungseigenschaften für die erfindungsgemäße Platine erzielt werden.

In dieser Ausführungsform der erfindungsgemäßen Platine ergibt sich ferner der wesentliche Vorteil, daß die Trägerplatte der Platine eine gute Leitfähigkeit sowohl für Wärme als auch für Strom aufweist, da sie notwendigerweise aus Metall ist. Dadurch kann einerseits die Wärme, die beim Betrieb des elektronischen Geräts entsteht, abgeführt werden. Andererseits kann dadurch in vorteilhafter Weise die auf der Trägerplatte angebrachte Leiterplatte gegen elektrische oder elektromagnetische Streustrahlung aus anderen Bereichen des elektronischen Geräts oder von der anderen Seite der Platine abgeschirmt werden.

Bevorzugte Ausführungsformen der erfindungsgemäßen Platine sind in den Ansprüchen 2 und 3 beschrieben.

Für diese bevorzugte Ausführungsform hat es sich als vorteilhaft erwiesen, die Trägerplatte aus Aluminium oder einer Aluminiumlegierung auszubilden. In gleicher Weise sind jegliche metallische oder auch nichtmetallische Werkstoffe mit einer Aluminiumplattierung bzw. Aluminiumbeschichtung geeignet. Ferner können für die Trägerplatte Metalle verwendet werden, die ihrerseits elektrochemisch oxidierbar sind.

Schließlich wird für die erfindungsgemäße Platine bevorzugt, daß die Leiterplatte mittels eines aushärtbaren Klebstoff, vorzugsweise eines Polyurethan-Epoxidharz-Systems oder eines keramischen Kitts angebracht ist. Für die genannten Verbindungsmittel haben sich bei Versuchen gute Haftungseigenschaften der Leiterplatte an der Trägerplatte herausgestellt. Mit einem derartigen Verbindungsmittel hält die Platine auch den Belastungen durch Einwirkung chemischer Verbindungen, wie z.B. Galvanikbädern, und durch Einwirkung von Hitze, wie in den Lötöfen, gut stand.

Gemäß einem weiteren Aspekt wird mit der Erfindung ein Verfahren zur Herstellung einer Platine für integrierte elektronische Schaltungen vorgestellt, das die Merkmale des Anspruchs 4 aufweist.

Demzufolge wird bei einem erfindungsgemäßen Verfahren zunächst eine Trägerplatte, z.B. ein Schichtstoff, bereitgestellt. Anschließend wird eine Oberfläche der metallenen Trägerplatte in einem Elektrolyt zur Ausbildung einer porösen Oxidschicht anodisiert. Nachfolgend wird bei reduzierter Spannung die zumindest eine Oberfläche der Trägerplatte weiter anodisiert, so daß in der anodisierten Oxidschicht eine vergleichsweise schwache Zwischenschicht ausgebildet wird. Daran anschließend wird die Trägerplatte in dem Elektrolyten oder einem anderen sauren Bad belassen, so daß die Zwischenschicht weiter geschwächt wird. Schließlich wird auf zumindest eine Oberfläche der Trägerplatte, die in der beschriebenen Weise behandelt wurde, eine Leiterplatte mittels eines Haftmittels aufgebracht.

In dieser Ausführungsform stellt das erfindungsgemäße Verfahren die Verwendung eines bekannten Verfahrens zur Ausbildung einer porösen anodisierten Oxidschicht mit einer vergleichsweise schwachen Zwischenschicht an einer Metallschicht dar. Folglich kann die Erfindung in diesem Fall auch in der Verwendung dieses Verfahrens bei der Herstellung einer Trägerplatte einer Platine zur Anbringung einer Leiterplatte auf der Oxidschicht der Trägerplatte bzw. in der Verwendung einer anodisierten Oxidschicht zur Herstellung einer trennbaren Platine gesehen werden. Das genannte Verfahren ist für einen deutlich anderen Anwendungsbereich, nämlich das abziehbare Anbringen eines Deckels aus Metallfolie auf einem Behälter, aus der EP 0 606 309 B1 bekannt, deren Offenbarung hiermit vollständig zum Gegenstand der vorliegenden Anmeldung gemacht wird. Im Rahmen der vorliegenden Erfindung entfaltet dieses Verfahren völlig unerwartete Vorteile für die Herstellung entsorgungsgerecht gestalteter Platinen. Es kann nämlich auf einfache Weise eine Befestigung einer Leiterplatte mit daran angebrachten elektronischen Bauteilen an der Trägerplatte einer Platine erreicht werden, die einerseits den Belastungen durch Hitze und durch Krafteinwirkung im Rahmen der automatischen Bestückung und Handhabung standhält. Andererseits ist zum Zeitpunkt der Entsorgung auf einfache Weise mit wenig Kraftaufwand das Abziehen der Leiterplatte von einem wesentlichen Teil der Trägerplatte möglich, die im Falle von Aluminium problemlos durch Einschmelzen der Wiederverwendung zugeführt werden kann. Ferner können in dieser Ausführungsform des erfindungsgemäßen Verfahrens für die erhaltene Platine diejenigen Vorteile erreicht werden, die vorangehend für die Verwendung einer Trägerplatte aus Metall beschrieben wurden.

## Patentansprüche

1. Platine für integrierte elektronische Schaltungen mit:
- einer Trägerplatte aus Metall, die im Bereich zumindest einer ihrer Oberflächen eine poröse anodisierte Oxidschicht aufweist, und
- zumindest einer Leiterplatte in Form einer dünnen Folie oder Karte, die mittels eines Haftmittels an der mit der Oxidschicht versehenen Oberfläche der Trägerplatte angebracht ist,
**dadurch gekennzeichnet, dass** in dem Verlauf der Porenöffnungen der Oxidschicht zusätzlich geschwächte Bereiche ausgebildet sind, die in ihrer Gesamtheit eine deutlich geschwächte Schicht innerhalb der Oxidschicht bilden.

2. Platine nach Anspruch 1,
**dadurch gekennzeichnet, dass**
die Trägerplatte aus Aluminium oder einer Aluminiumlegierung besteht.

3. Platine nach Anspruch 1 oder 2,
**dadurch gekennzeichnet, dass**
die Leiterplatte mittels eines aushärtbaren Klebstoffs, vorzugsweise eines Polyurethan-Epoxidharz-Systems oder eines keramischen Kitts angebracht ist.

4. Verfahren zur Herstellung einer Platine für integrierte elektronische Schaltungen gemäß Anspruch 1 mit den Schritten:
(a) Bereitstellen einer Trägerplatte mit zumindest einer metallischen, anodisch oxidierbaren Oberflächenschicht,
(b) Anodisieren zumindest einer Oberfläche der Trägerplatte in einem Elektrolyten zur Ausbildung einer porösen anodisierten Oxidschicht,
(c) weiteres Anodisieren zumindest einer Oberfläche der Trägerplatte mit reduzierter Spannung zur Schwächung der anodisierten Oxidschicht,
(d) Belassen der anodisierten Trägerplatte in dem Elektrolyten oder einem anderen sauren Bad zur weiteren Schwächung der anodisierten Oxidschicht, und
(e) Aufbringen einer Leiterplatte auf der zumindest einen anodisch oxidierten Oberfläche der Trägerplatte mittels eines Haftmittels.

5. Verwendung einer porösen anodisierten Oxidschicht zur Herstellung einer Trägerplatte einer Platine gemäß Anspruch 1.

## Claims

1. Printed circuit board for integrated electronic circuits comprising:
- a metal supporting plate that has a porous anodized oxide layer in the region of at least one of its surfaces, and
- at least one conductor board in the form of a thin film or card that is applied to that surface of the supporting plate provided with the oxide layer by means of an adhesive,
**characterized in that** there are formed, in the extension of the pore openings of the oxide layer, additionally weakened regions that form, in their totality, a markedly weakened layer within the oxide layer.

2. Printed circuit board according to Claim 1, **characterized in that** the supporting plate is composed of aluminium or an aluminium alloy.

3. Printed circuit board according to Claim 1 or 2, **characterized in that** the conductor board is applied by means of a curable adhesive, preferably a polyurethane/epoxide resin system or a ceramic cement.

4. Method of producing a printed circuit board for integrated electronic circuits in accordance with Claim 1, comprising the steps of:
(a) providing a supporting plate having at least one metallic, anodically oxidizable surface layer,
(b) anodizing at least one surface of the supporting plate in an electrolyte to develop a porous anodized oxide layer,
(c) further anodizing at least one surface of the supporting plate at reduced voltage to weaken the anodized oxide layer,
(d) leaving the anodized supporting plate in the electrolyte or in another acidic bath to weaken the anodized oxide layer further, and
(e) applying a conductor board to the at least one anodically oxidized surface of the supporting plate by means of an adhesive.

5. Use of a porous anodized oxide layer to produce a supporting plate of a printed circuit board in accordance with Claim 1.

## Revendications

1. Platine pour circuits intégrés électroniques avec :
- une plaque de support en métal qui présente dans la zone d'au moins une de ses surfaces une couche d'oxyde anodisée poreuse et
- au moins une plaque conductrice sous forme d'une fine feuille ou carte qui est appliquée au moyen d'un agent adhésif sur la surface de la plaque de support pourvue d'une couche d'oxyde,
**caractérisée en ce que** dans l'étendue des ouvertures des pores de la couche d'oxyde sont constituées en plus des zones fragilisées qui forment dans leur ensemble une couche nettement affaiblie à l'intérieur de la couche d'oxyde.

2. Platine selon la revendication 1, **caractérisée en ce que** la plaque de support est en aluminium ou en alliage d'aluminium.

3. Platine selon la revendication 1 ou 2, **caractérisée en ce que** la plaque conductrice est appliquée au moyen d'une substance adhésive pouvant durcir, de préférence un système à résine époxy et polyuréthanne ou un mastic céramique.

4. Procédé de fabrication d'une platine pour circuits intégrés électroniques selon la revendication 1 avec les étapes consistant à :
(a) préparer une plaque de support avec au moins une couche superficielle métallique oxydable par anodisation,
(b) anodiser au moins une surface de la plaque de support dans un électrolyte afin de former une couche d'oxyde anodisée poreuse,
(c) anodiser en plus au moins une surface de la plaque de support avec une tension réduite afin de fragiliser la couche d'oxyde anodisée,
(d) laisser la plaque de support anodisée dans l'électrolyte ou dans un autre bain acide en vue d'une fragilisation supplémentaire de la couche d'oxyde anodisée et
(e) appliquer une plaque conductrice sur la surface anodisée de la plaque de support au moyen d'un agent adhésif.

5. Utilisation d'une couche d'oxyde anodisée poreuse pour fabriquer une plaque de support d'une platine selon la revendication 1.
